# EUROPEAN PATENT SPECIFICATION

(11) **EP 0 646 660 B1**
(45) Date of publication and mention of the grant of the patent: **30.07.1997**
(21) Application number: 94202789.7
(22) Date of filing: 27.09.1994
(51) Int. Cl.: C23C 14/48, C03C 17/36

(54) **Production of carriers for surface plasmon resonance**
Herstellung von Träger für Oberflächenplasmonresonanz
Fabrication de supports pour la résonance de plasmone en surface

(30) Priority: 01.10.1993 GB 9320307
(43) Date of publication of application: 05.04.1995
(73) Proprietor: KODAK LIMITED, Harrow, Middlesex HA1 4TY (GB); Johnson & Johnson Clinical Diagnostics, Inc., Rochester New York 14650 (US)
(72) Inventor: Sunderland, Robert Frank, Kodak Limited, Harrow, Middlesex, HA1 4TY (GB)
(74) Representative: Mercer, Christopher Paul

(56) References cited:
- EP-A- 0 111 957
- FR-A- 956 638
- FR-A- 2 106 431
- US-A- 3 476 594
- US-A- 5 151 956
- CHEMICAL ABSTRACTS, vol. 96, no. 8, 22 February 1982, Columbus, Ohio, US; abstract no. 56765c, ASAHI GLASS 'infrared-reflecting glasses' page 299 ;column 96 ;

## Description

This invention relates to a process for the production of carriers for surface plasmon resonance (SPR).

Surface plasmon resonance or (SPR) is a technique which can be used in the analysis of antibodies which are deposited on surfaces which have been coated with thin films of silver. SPR based sensors are discussed in a paper by I Faulkner, W R Flavell, J Davies, R F Sunderland and C S Nunnerly : "SPR-based sensors studied by electron energy loss spectroscopy and attenuated total reflection" - to be published in J Electron Spectroscopy, 1993. The manner in which a coating is applied to a surface has important consequences for the subsequent properties of that surface in terms of SPR and control of the coating process is important. At present coating is generally performed by spattering but control is not good. It is important that the films are formed from uniform layers of metal in order to get reproducible SPR. On account of this improved methods for the production of films for SPR are desirable.

According to the present invention we provide a process for the production of a carrier for SPR analysis in which a metallic film (preferably thin) comprising a layer of silver is deposited on a surface characterised in that after the silver layer has been deposited the film is subjected to an annealing step in which it is heated to a temperature sufficient to anneal it.

In the annealing step the film is annealed effectively in order to bake it and thereby to orient the film and enhance its physical properties.

In operation of the process of the invention the surface, which is suitably a glass surface, is preferably subjected to an appropriate pre-treatment before the silver layer is laid down upon it. A suitable pre-treatment comprises the steps of cleaning, treatment by reactive glow discharge and thereafter deposition of a preparatory metallic layer. The preparatory metallic layer is preferably thin. The silver layer is then deposited on the preparatory layer. After the silver layer has been deposited it is annealed.

The annealing step is carried out effectively to bake the metallic film. It has the effect of orienting the film and enhancing its physical properties. Suitably annealing is effected by infra red heating in a chamber. The preferred period is in the range 1.5 to 4 hours. The preferred temperature is in the range 125° to 175°C. A temperature of 150° is especially preferred The annealing temperature is important when SPR is to be used to analyse the binding of antibodies. It is less important for analysing the binding of compounds such as dextran.

Preferably the surface is a glass surface. Any suitable glass surface may be used but a preferred surface has a silicon dioxide surface layer. Particularly suitable types of glass are "PERMABLOC"⁽™⁾ and the earlier product "PERMASHEET"⁽™⁾ glass, both manufactured by Pilkington Glass of St Helens, England. These have consistent top layers of silicon dioxide.

In the pre-treatment the glass can be cleaned by any suitable means. Preferred treatments include treating with a freon and/or ultrasonic treatment and thereafter with a vapour bath or blow drying.

After cleaning the glass is suitably subjected to treatment with an oxygen-containing gas. Any suitable treatment may be used which will cause oxygen ions to enter the surface to an extent sufficient to sensitise it. Preferably the surface is subjected to a reactive glow discharge treatment which suitably uses a mixture of oxygen and an inert gas in particular argon. The surface can be put into a vacuum system in a clean room environment. It may then be subjected to reactive glow discharge using a mixture of oxygen and a rare gas containing suitably 5% to 15% oxygen. A preferred treatment uses a mixture of argon (90%) and Oxygen (10%). The treatment time is suitably 1 to 5 minutes with 2 minutes being preferred. Prior to this procedure the chamber is suitably pumped to a high vacuum. The organic vapour is suitably low or negligible.

In the pre-treatment, when reactive glow discharge treatment has been completed a thin preparatory metallic layer suitably deposited on the glass to form a base for the silver layer. This preparatory layer suitably comprises a major proportion of titanium, nickel and/or chromium, preferably being composed essentially of one of these metals, nickel being preferred. It is suitably deposited using an electron beam source. Suitably it has a thickness in the range 20Å to 40Å, preferably 20Å to 30Å and especially 25Å to 30Å.

When any pre-treatment has been completed, the silver layer is deposited on the preparatory metallic layer, suitably soon and preferably immediately after the latter has been formed. Suitably the silver layer has a thickness in the range 500Å to 600Å, preferably 520Å. This has been found to give the optimum SPR response. The deposit of the silver layer is suitably made at a low rate, being preferably at a rate between 0.5Å and 5.0Å per second and especially 1.0Å per second.

The annealing step is carried out after the silver layer has been deposited. Preferably it is carried out immediately after the deposit of the silver layer but the presence of one or more intermediate steps is not precluded.

The invention is illustrated by the following example:-

### Example

A sheet of "PERMASHEET"⁽™⁾ glass obtained from Pilkingtons Glass, St Helens, England was cleaned by ultrasonic treatment with a freon liquid, followed by freon vapour drying to eliminate streaking marks.

The cleaned sheet was then put into a vacuum system in a clean room environment and evacuated to approximtely 10⁻⁷m bar in an oil-free environment. It was then subjected to reactive glow discharge using a gaseous mixture comprising 90% argon and 10% oxygen for a 2 minute period. This was done by admitting a small amount of the gaseous mixture to the system and pumping at a pressure of 20 to 60 microns while applying a voltage of 300V to an electrode for 2 minutes. As a result of this treatment oxygen ions have sufficient energy to enter the surface of the glass and sensitise it. The equipment used was a Temescale 2550 coating system using a Telemark 4 crucible e-gun evaoration with Sycon controller.

After reactive glow discharge treatment the system was repumped to approximately 10⁻⁷m bar. Then a thin layer of nickel from a 99.9% pure ingot produced by Materials Research Corporation (MCR) was laid down upon the glass surface using an electron beam source. A tuypical beam current was 60mA at 10 KeV energy. The layer was 25Å to 30Å in thickness. Deposition time was 25 to 30 seconds at 1Å per second.

Immediately after the layer of nickel had been laid down a layer of silver from a 99.9% pure ingot from MCR was laid upon it using the same technique. A typical beam current was 50mÅ at 10 KeV. The silver layer was 520Å in thickness. Deposition time was 8.5 minutes at 1Å per second.

After deposit of the silver layer annealing was effected by placing the coated glass surface in a chamber and subjecting it to infra red heating at 150°C for 4 hours.

The silver coated glass surface produced had a very suitable SPR response.

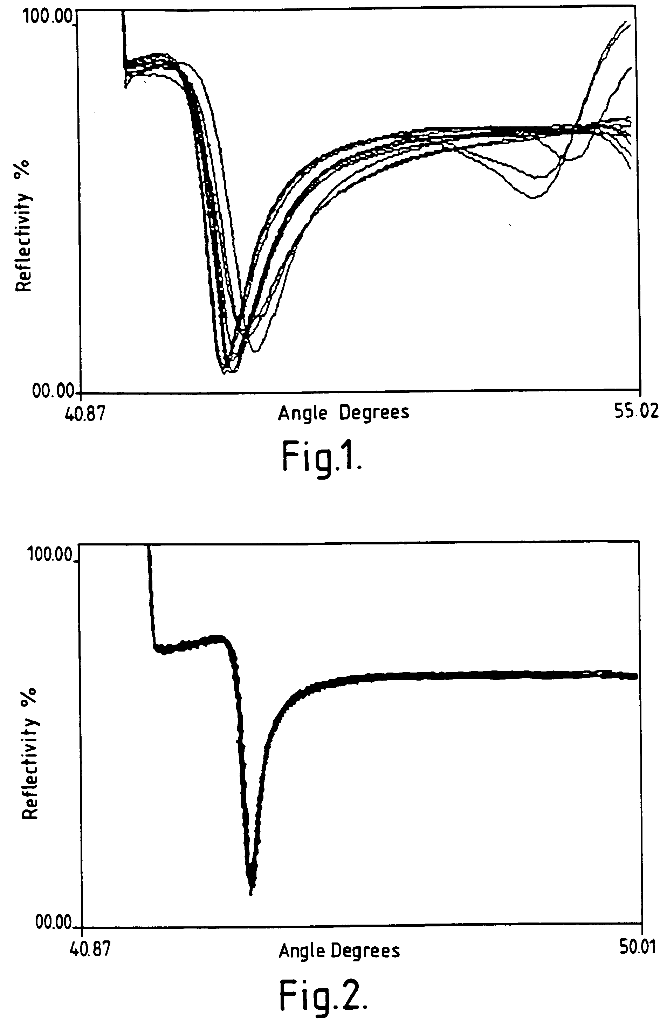

This is illustrated by Figures 1 and 2 of the accompanying drawings wherein:-
Figure 1 is a graph of percentage light transmitted against angular position for a conventional commercially available SPR system; and
Figure 2 is a graph of percentage light transmitted against angular position for the system of the Example.

The Figures show that the characteristics produced by the Example are superior, giving a sharper, more distinct minimum in the curve.

Figure 1 relates to an air SPR of typically commercially available slides of approximately 410Å gold (measured by optical density) with assay material removed from the gold surface.

Figure 2 relates to aire SPR and to slides prepared by the process of the invention of approximately 560Å silver with underlay measured by optical density.

## Claims

1. A process for the production of a carrier for surface plasmon resonance analysis (SPR) in which a metallic film comprising a layer of silver is deposited on a surface characterised in that after the silver layer has been deposited the film is subjected to an annealing step in which it is heated to a temperature sufficient to anneal it.

2. A process according to claim 1 characterised in that during the annealing step the film is heated for a period in the range 1.5 to 4 hours.

3. A process according to claim 1 or claim 2 characterised in that during the annealing step the film is heated to a temperature in the range 125° to 175°C.

4. A process according to any one of the preceding claims characterised in that the surface is glass coated with a silicon dioxide surface layer.

5. A process according to any one of the preceding claims characterised in that the silver layer has a thickness in the range 500Å to 600Å.

6. A process according to any one of the preceding claims characterised in that a preparatory metallic layer comprising a major proportion of titanium, nickel and/or chromium is deposited before the silver layer.

7. A process according to claim 6 characterised in that the preparatory metallic layer is formed essentially from nickel.

8. A process according to claim 6 or claim 7 characterised in that the preparatory metallic layer has a thickness in the range 20Å to 40Å.

9. A process according to any one of the preceding claims characterised in that before the silver layer is deposited the surface is subjected to a pre-treatment comprising the steps of cleaning, treatment by reactive glow discharge and thereafter deposition of a preparatory metallic layer.

10. A process according to claim 8 characterised in that the reactive glow discharge treatment uses a mixture of oxygen and argon containing 5% to 15% oxygen.

## Patentansprüche

1. Verfahren zur Herstellung eines Trägers für die Oberflächen-Plasmonresonanz-Analyse (SPR), bei dem ein Metallfilm, der eine untere vorbereitende Schicht aus einem ersten Metall und eine obere Schicht aus Silber umfaßt, auf einer Oberfläche abgeschieden wird, dadurch gekennzeichnet, daß die untere vorbereitende Schicht einen überwiegenden Anteil an Nickel enthält.

2. Verfahren nach Anspruch 1, dadurch gekennzeichnet, daß nach der Abscheidung der Silberschicht der Film einer Temperungsstufe durch Erhitzen während einer Dauer im Bereich von 1,5 bis 4 Stunden unterworfen wird.

3. Verfahren nach Anspruch 1 oder Anspruch 2, dadurch gekennzeichnet, daß der Film während der Temperungsstufe auf eine Temperatur im Bereich von 125 bis 175°C erhitzt wird.

4. Verfahren nach einem der vorhergehenden Patentansprüche, dadurch gekennzeichnet, daß die Oberfläche aus mit einer Siliciumdioxid-Oberflächenschicht beschichtetem Glas besteht.

5. Verfahren nach einem der vorhergehenden Patentansprüche, dadurch gekennzeichnet, daß die Silberschicht eine Dicke im Bereich von 500 Å bis 600 Å hat.

6. Verfahren nach einem der vorhergehenden Patentansprüche, dadurch gekennzeichnet, daß die vorbereitende Metallschicht im wesentlichen vollständig aus Nickel ausgebildet wird.

7. Verfahren nach einem der Ansprüche 1 bis 5, dadurch gekennzeichnet, daß die vorbereitende Metallschicht zusätzlich zu Nickel Titan und/oder Chrom enthält.

8. Verfahren nach einem der vorhergehenden Patentansprüche, dadurch gekennzeichnet, daß die vorbereitende Metallschicht eine Dicke im Bereich von 20 Å bis 40 Å hat.

9. Verfahren nach einem der vorhergehenden Patentansprüche, dadurch gekennzeichnet, daß vor dem Abscheiden der unteren vorbereitenden Schicht die Oberfläche einer Vorbehandlung unterworfen wird, welche die Stufen des Reinigens und der Behandlung durch reaktive Glimmentladung umfaßt.

10. Verfahren nach Anspruch 8, dadurch gekennzeichnet, daß die Behandlung durch reaktive Glimmentladung mit Hilfe eines Gemisches aus Sauerstoff und Argon mit einem Sauerstoffgehalt von 5 bis 15 % durchgeführt wird.

## Revendications

1. Procédé pour la production d'un support pour analyse par résonance de plasmon en surface (SPR), dans lequel un film métallique comprenant une couche d'argent est déposé sur une surface, caractérisé en ce que, après que la couche d'argent a été déposée, le film est soumis à une étape de recuit au cours de laquelle il est chauffé à une température suffisante pour être recuit.

2. Procédé selon la revendication 1, caractérisé en ce que, pendant l'étape de recuit, le film est chauffé pendant une durée comprise entre 1,5 et 4 heures.

3. Procédé selon la revendication 1 ou 2, caractérisé en ce que, pendant l'étape de recuit, le film est chauffé à une température comprise entre 125 et 175°C.

4. Procédé selon l'une quelconque des revendications précédentes, caractérisé en ce que la surface est émaillée avec une couche superficielle de dioxyde de silicium.

5. Procédé selon l'une quelconque des revendications précédentes, caractérisé en ce que la couche d'argent a une épaisseur comprise entre 500 et 600 Å.

6. Procédé selon l'une quelconque des revendications précédentes, caractérisé en ce qu'on dépose avant la couche d'argent une couche métallique préparatoire comprenant une proportion principale de titane, de nickel et/ou de chrome.

7. Procédé selon la revendication 6, caractérisé en ce que la couche métallique préparatoire est constituée essentiellement de nickel.

8. Procédé selon la revendication 6 ou 7, caractérisé en ce que la couche métallique préparatoire a une épaisseur comprise entre 20 et 40 Å.

9. Procédé selon l'une quelconque des revendications précédentes, caractérisé en ce que, avant que la couche d'argent ne soit déposée, la surface est soumise à un traitement préalable comprenant les étapes de nettoyage, de traitement par décharge luminescente réactive, puis déposition d'une couche métallique préparatoire.

10. Procédé selon la revendication 8, caractérisé en ce que le traitement par décharge luminescente réactive utilise un mélange d'oxygène et d'argon contenant de 5 à 15 % d'oxygène.
